# EUROPÄISCHE PATENTSCHRIFT

(11) **EP 1 676 346 B1**
(45) Veröffentlichungstag und Bekanntmachung des Hinweises auf die Patenterteilung: **21.03.2007**
(21) Anmeldenummer: 04790425.5
(22) Anmeldetag: 14.10.2004
(51) Int. Cl.: H01S 5/183, H01S 5/323, H01S 5/042

(54) **OBERFLÄCHENEMITTIERENDER HALBLEITERLASER MIT STRUKTURIERTEM WELLENLEITER**
SURFACE-EMITTING SEMICONDUCTOR LASER COMPRISING A STRUCTURED WAVEGUIDE
LASER A SEMI-CONDUCTEURS A EMISSION PAR LA SURFACE POURVU D'UN GUIDE D'ONDES STRUCTURE

(30) Priorität: 16.10.2003 DE 10348211; 19.11.2003 DE 10353960
(43) Veröffentlichungstag der Anmeldung: 05.07.2006
(73) Patentinhaber: Vertilas GMBH, 85748 Garching (DE)
(72) Erfinder: ORTSIEFER, Markus, 80939 München (DE)
(74) Vertreter: Grunert, Marcus
(86) Internationale Anmeldenummer: PCT/EP2004/011569
(87) Internationale Veröffentlichungsnummer: WO 2005/039003

(56) Entgegenhaltungen:
- US-A1- 2003 179 802
- ARZBERGER M ET AL: "Low-resistivity p-side contacts for InP-based devices using buried InGaAs tunnel junction" ELECTRONICS LETTERS, IEE STEVENAGE, GB, Bd. 36, Nr. 1, 6. Januar 2000 (2000-01-06), Seiten 87-88, XP006014657 ISSN: 0013-5194
- ORTSIEFER M ET AL: "LOW-RESISTANCE INGA(AL)AS TUNNEL JUNCTIONS FOR LONG WAVELENGTH VERTICAL-CAVITY SURFACE-EMITTING LASERS" JAPANESE JOURNAL OF APPLIED PHYSICS, PUBLICATION OFFICE JAPANESE JOURNAL OF APPLIED PHYSICS. TOKYO, JP, Bd. 39, Nr. 4A, PART 1, 1. April 2000 (2000-04-01), Seiten 1727-1729, XP001014927 ISSN: 0021-4922
- ORTSIEFER M ET AL: "Low-threshold index-guided 1.5 micron long-wavelength vertical-cavity surface-emitting laser with high efficiency" APPLIED PHYSICS LETTERS, AMERICAN INSTITUTE OF PHYSICS. NEW YORK, US, Bd. 76, Nr. 16, 17. April 2000 (2000-04-17), Seiten 2179-2181, XP012025060 ISSN: 0003-6951
- OH T-H ET AL: "SINGLE-MODE OPERATION IN AN ANTIGUIDED VERTICAL-CAVITY SURFACE- EMITTING LASER USING A LOW-TEMPERATURE GROWN ALGAAS DIELECTRIC APERTURE" IEEE PHOTONICS TECHNOLOGY LETTERS, IEEE INC. NEW YORK, US, Bd. 10, Nr. 8, August 1998 (1998-08), Seiten 1064-1066, XP000769857 ISSN: 1041-1135
- CHOQUETTE K D ET AL: "Leaky mode vertical cavity lasers using cavity resonance modification" ELECTRONICS LETTERS, IEE STEVENAGE, GB, Bd. 34, Nr. 10, 14. Mai 1998 (1998-05-14), Seiten 991-993, XP006009777 ISSN: 0013-5194
- ORTSIEFER M ET AL: "Submilliamp long-wavelength InP-based vertical-cavity surface-emitting laser with stable linear polarisation" ELECTRONICS LETTERS, IEE STEVENAGE, GB, Bd. 36, Nr. 13, 22. Juni 2000 (2000-06-22), Seiten 1124-1126, XP006015366 ISSN: 0013-5194
- SHAU R ET AL: "InP-based vertical-cavity surface-emitting lasers for 1.5-1.8 /spl mu/m wavelength range" SEMICONDUCTOR LASER CONFERENCE, 2000. CONFERENCE DIGEST. 2000 IEEE 17TH INTERNATIONAL 25-28 SEPT. 2000, PISCATAWAY, NJ, USA,IEEE, 25. September 2000 (2000-09-25), Seiten 153-154, XP010521565 ISBN: 0-7803-6259-4

## Beschreibung

Die Erfindung betrifft einen oberflächenemittierenden Halbleiterlaser mit strukturiertem Wellenleiter.

Oberflächenemittierende Laserdioden (engl.: Vertical-Cavity Surface-Emitting Laser: VCSEL) stellen Halbleiterlaser dar, bei denen die Lichtemission senkrecht zur Oberfläche des Halbleiterchips stattfindet. Verglichen mit konventionellen kantenemittierenden Laserdioden weisen die oberflächenemittierenden Laserdioden mehrere Vorteile auf, wie einen geringen elektrischen Leistungsverbrauch, die Möglichkeit der unmittelbaren Überprüfung der Laserdiode auf dem Wafer, einfache Ankopplungsmöglichkeiten an eine Glasfaser, longitudinale Einmodenspektren und die Möglichkeit der Zusammenschaltung der oberflächenemittierenden Laserdioden zu einer zweidimensionalen Matrix.

Auf dem Gebiet der Kommunikationstechnik mittels Glasfasern besteht aufgrund der wellenlängenabhängigen Dispersion und Absorption das Bedürfnis nach VCSELs in einem Wellenlängenbereich von ca. 1,3 bis 2 µm, insbesondere um die Wellenlängen von 1,31 µm oder 1,55 µm. Solche langwelligen Laserdioden werden bislang aus InP-basierten Verbindungshalbleitern hergestellt. GaAs-basierte VCSELs sind für den kurzwelligen Bereich < 1,3 µm geeignet.

Die bisherigen Lösungsmethoden lassen sich wie folgt zusammenstellen:

Das laterale Strahlprofil von Laserdioden kann in hohem Maße durch die Definition des entsprechenden Wellenleiters beeinflusst werden. Bei GaAs-basierten VCSELs mit Emissionswellenlängen unterhalb ca. 1,3 µm wird die Wellenführung durch selektiv oxidierte Al(Ga)As-Schichten erzeugt, vergl. hierzu "Electrically Pumped 10 Gbit/s MOVPE Grown Monolithic 1.3 µm VCSEL with GaInNAs Active Region", ELECTRONICS LETTERS, 28. März 2002, Vol. 38, No. 7, Seiten 322 bis 324.

Die mit Abstand besten Resultate für langwellige VCSELs im Wellenlängenbereich oberhalb 1,3 µm hinsichtlich Leistung, Betriebstemperatur, Einmodenleistung sowie Modulationsbandbreite weisen InP-basierte BTJ-VCSEL auf (engl.: Buried Tunnel Junction, BTJ).

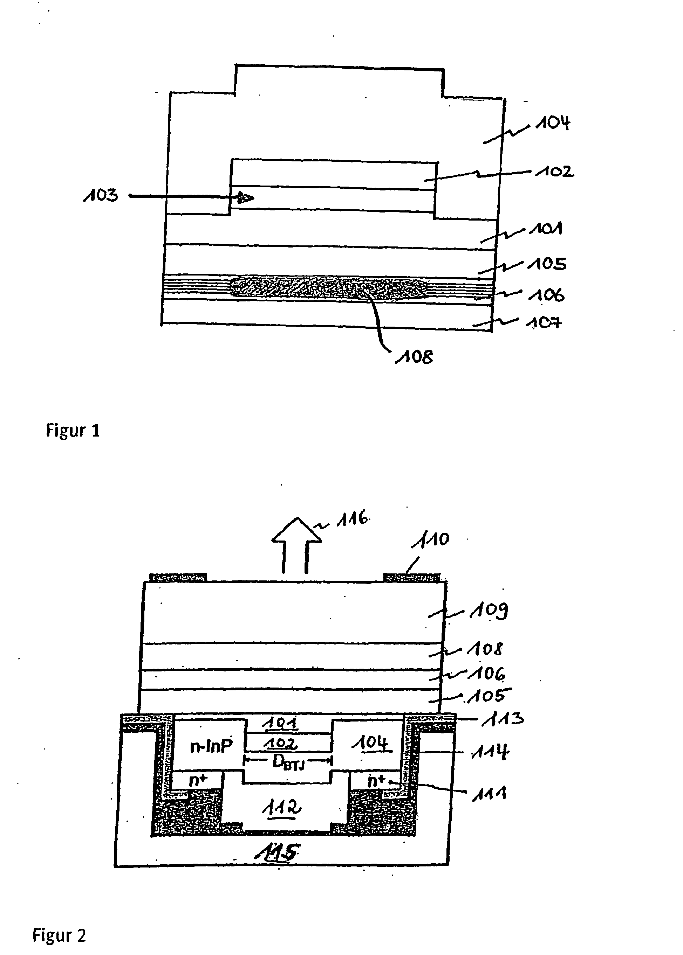

Herstellung und Struktur des vergrabenen Tunnelkontakts sollen beispielhaft zunächst anhand Figur 1 dargelegt werden. Mittels Molekularstrahlepitaxie (engl.: Molecular Beam Epitaxy, MBE) wird ein hochdotiertes p⁺/n⁺-Schichtenpaar 101, 102 mit geringem Bandabstand hergestellt. Zwischen diesen Schichten bildet sich der eigentliche Tunnelkontakt 103 aus. Durch reaktives Ionenätzen (engl.: Reactive Ion Etching, RIE) wird ein kreisförmiger oder elliptischer Bereich geformt, der im Wesentlichen durch die n⁺-dotierte Schicht 102, den Tunnelkontakt 103 sowie eines Teils oder der gesamten p⁺-dotierten Schicht 101 gebildet wird. Dieser Bereich wird in einem zweiten Epitaxiedurchlauf mit n-dotiertem InP (Schicht 104) überwachsen, so dass der Tunnelkontakt 103 "vergraben" ist. Der Kontaktbereich zwischen der überwachsenen Schicht 104 und der p⁺-dotierten Schicht 101 wirkt beim Anlegen einer Spannung als Sperrschicht. Der Strom fließt durch den Tunnelkontakt mit Widerständen von typisch 3 × 10⁻⁶ Ω cm². Hierdurch kann der Stromfluss auf den eigentlichen Bereich der aktiven Zone 108 beschränkt werden. Weiterhin ist die Wärmeerzeugung gering, da der Strom von einer hochohmigen p-dotierten zu einer niederohmigen n-dotierten Schicht fließt.

Die Überwachsung des Tunnelkontakts führt - wie anhand von Figur 2 veranschaulicht wird - zu leichten Dickenvariationen der darüber liegenden Schichten, was sich ungünstig auf die laterale Wellenführung auswirkt. Das Entstehen höherer lateraler Moden ist insbesondere bei größeren Aperturen erleichtert. Für den - insbesondere bei der glasfaseroptischen Kommunikationstechnik geforderten - Einmodenbetrieb können daher nur kleine Aperturen mit entsprechend geringer Laserleistung eingesetzt werden.

Die vollständige Struktur eines InP-basierten VCSEL soll nun beispielhaft anhand Figur 2 erläutert werden.

Der vergrabene Tunnelkontakt (BTJ) ist in dieser Struktur umgekehrt angeordnet, so dass die aktive Zone 106 oberhalb des Tunnelkontakts (Durchmesser D_{BTJ}) zwischen der p⁺-dotierten Schicht 101 und der n⁺-dotierten Schicht 102 gelegen ist. Die Laserstrahlung tritt in der mit dem Pfeil 116 dargestellten Richtung aus. Die aktive Zone 106 ist von einer p-dotierten Schicht 105 (z. B. InAlAs) und von einer n-dotierten Schicht 108 (z. B. InAlAs) umgeben. Der vorderseitige Spiegel 109 oberhalb der aktiven Zone 106 besteht aus einem epitaktischen DBR (Distributed Bragg Reflector) mit etwa 35 Schichtpaaren InGa(Al)As/InAlAs, wodurch sich eine Reflektivität von etwa 99,4 % ergibt. Der hinterseitige Spiegel 112 besteht aus einem Stapel dielektrischer Schichten als DBR und wird von einer Goldschicht abgeschlossen, wodurch sich eine Reflektivität von nahezu 99,75 % ergibt. Eine Isolierschicht 113 dient zur lateralen Isolation. Zwischen der Schicht 104 und der Kontaktschicht 114 ist eine ringförmig strukturierte weitere p-seitige Kontaktschicht 111 vorgesehen. Figur 2 zeigt anschaulich, wie sich die Struktur des überwachsenen Tunnelkontakts in die weiteren Schichten (hier: nach unten) fortpflanzt.

Die Kombination aus dielektrischem Spiegel 112 und der integrierten Kontaktschicht 114 und Wärmesenke 115 resultiert in einer stark erhöhten Wärmeleitfähigkeit verglichen mit epitaxialen Vielschichtstrukturen. Strom wird über die Kontaktschicht 114 bzw. über die integrierte Wärmesenke 115 und den n-seitigen Kontaktstellen 110 injiziert. Zu weiteren Einzelheiten bezüglich der Herstellung und den Eigenschaften solcher VCSEL-Typen sei ausdrücklich auf die nachfolgenden Literaturstellen hingewiesen.

Ein VCSEL der in Figur 2 dargestellten Struktur ist Gegenstand der Veröffentlichungen "Low-Threshold Index-Guided 1.5 µm Long-Wavelength Vertical-Cavity Surface-Emitting Laser with High Efficieny", Applied Physics Letters, Vol. 76, No. 16, Seiten 2179 - 2181 vom 17. April 2000; "Low-resistance InGa(Al)As Tunnel Junctions for Long Wavelength Vertical-cavity Surface-emitting Lasers", Japanese Journal of Applied Physics, Vol. 39, Part 1, No. 4A, Seiten 1727-1729, April 2000. Ein VCSEL des gleichen Typs mit einer Ausgangsleistung bis zu 7 mW (20°C, CW) ist in "Vertical-Cavity Surface-Emitting Laser Diodes at 1.55 µm with Large Output Power and High Operation Temperature" Electronics Letters, Vol. 37, No. 21, Seiten 1295 - 1296 vom 11. Oktober 2001 vorgestellt. Ein 1,83 µm InGaAlAs-InP VCSEL ist Gegenstand der Veröffentlichung "90°C Continuous-Wave Operation of 1.83-µm Vertical-Cavity Surface-Emitting Lasers", IEEE Photonics Technology Letters, Vol. 12, No. 11, Seiten 1435 - 1437, November 2000. Die Verwendung eines BTJ-VCSEL zur fehlerfreien Datenübertragung bei Modulationsfrequenzen bis zu 10 Gbit/s ist besprochen in "High-Speed Data Transmission with 1.55 µm Vertical-Cavity Surface-Emitting Lasers", Post-Deadline Papers, 28th European Conference on Optical Communication, September 8 - 12, 2002. Schließlich ist ein VCSEL mit einer Emissionswellenlänge von 2,01 µm (CW) aus "Electrically Pumped Room Temperature CW-VCSELs with Emission Wavelengths of 2 µm", Electronics Letters, Vol. 39, No. 1, Seiten 57 - 58, vom 9. Januar 2003, bekannt.

Im Gegensatz zu den GaAs-basierten VCSELs mit Emissionswellenlängen unterhalb 1,3 µm kann die Methode der lateralen Oxidation bei den hier besprochenen BTJ-VCSELs nicht angewendet werden, da bei den verwendeten Materialien die Aluminiumgehälter zu niedrig sind und auch denkbare Materialen wie AlAsSb bisher noch keine ausreichende Qualität der Oxidschichten ergaben. Daher erfolgt bei den oben besprochenen BTJ-VCSELs die laterale Wellenführung infolge des Herstellungsverfahrens durch laterale Variation der Resonatorlänge (vergl. "Low-resistance InGa(Al)As Tunnel Junctions for Long Wavelength Vertical-cavity Surface-emitting Lasers", Japanese Journal of Applied Physics, Vol. 39, Part 1, No. 4A, Seiten 1727-1729, April 2000). Alternativ hierzu kamen bei anderen langwelligen VCSEL-Konzepten zum Beispiel selektiv abgeätzte Schichten (vergl. "1.55-µm InP-lattice-matched VCSELs with AlGaAsSb-AlAsSb DBRs", IEEE Journal on Selected Topics in Quantum Electronics, Vol. 7, No. 2, March/April 2001, Seiten 224 bis 230), Protonenimplantation (vergl. "Metamorphic DBR and Tunnel-Junction Injection: A CW RT Monolithic Long-Wavelength VCSEL", IEEE Journal on Selected Topics in Quantum Electronics, Vol. 5, No. 3, May/June 1999, Seiten 520 bis 529) oder selektiv oxidierte metamorphe AlAs-Schichten zum Einsatz (vergl. "1.5 - 1.6 µm VCSEL for Metro WDM Applications", 2001 International Conference on Indium Phosphide and Related Materials, Conference Proceedings, 13th IPRM, 14 - 18 May 2001, Nara, Japan).

Ziel der Erfindung ist es nunmehr, die bei BTJ-VCSELs üblicherweise starke und Mehrmodenbetrieb begünstigende Indexführung durch eine schwächere Indexführung bzw. Gewinnführung zu ersetzen sowie gegebenenfalls höhere laterale Moden zu dämpfen. Durch die Einstellung des lateralen Modenprofils soll ein Einmodenbetrieb auch bei großen Aperturen mit höheren Einmodenleistungen als bei herkömmlichen BTJ-VCSELs ermöglicht werden.

Dieses Ziel wird erreicht durch den beanspruchten oberflächenemittierenden Halbleiterlaser gemäß Erfindung. Weitere Ausgestaltungen ergeben sich aus den jeweiligen Unteransprüchen und der nachfolgenden Beschreibung.

Erfindungsgemäß wird ein oberflächenemittierender Halbleiterlaser vorgeschlagen, der eine einen pn-Übergang aufweisende aktive Zone, umgeben von einer ersten n-dotierten Halbleiterschicht und mindestens einer p-dotierten Halbleiterschicht aufweist, sowie eine Tunnelkontaktschicht auf der p-Seite der aktiven Zone, wobei die Tunnelkontaktschicht eine Apertur mit einem Aperturdurchmesser und einer Aperturtiefe aufweist und von einer n-dotierten Stromführungsschicht bedeckt ist, so dass die angrenzende Stromführungsschicht im Bereich der Apertur eine Überhöhung mit einem Überhöhungsdurchmesser und einer Überhöhungstiefe aufweist, wobei auf der Stromführungsschicht zumindest um den lateralen Bereich der Überhöhung herum, angrenzend zu dieser oder einen Höchstabstand von 2 µm zu dieser Überhöhung einhaltend, eine strukturierte Schicht vorgesehen ist, deren Dicke derart gewählt ist, dass deren optische Dicke mindestens gleich der optischen Dicke der Stromführungsschicht im Bereich der Überhöhungstiefe ist.

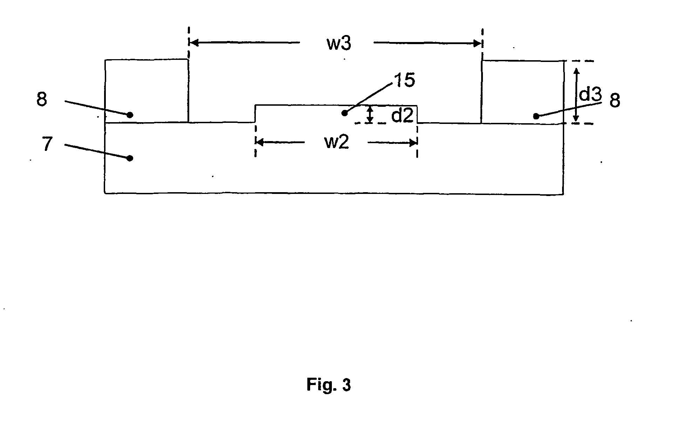

Zum besseren Verständnis der vorliegenden Erfindung sollen zunächst die Verhältnisse bei einer bekannten Struktur eines gattungsgemäßen oberflächenemittierenden Halbleiterlaser, wie er in der Beschreibungseinleitung ausführlich dokumentiert worden ist, dargelegt werden. Hierzu wird auf Figur 3 verwiesen, die schematisch und nicht maßstabsgerecht die Verhältnisse bei einer bekannten Struktur eines gattungsgemäßen oberflächenemittierenden Halbleiterlasers darstellt. Dargestellt ist der Grenzbereich zwischen Stromführungsschicht 7 und einer n-dotierten Kontaktschicht 8, durch die in der Regel die Stromzuführung erfolgt, und die vorzugsweise aus hoch-n-dotiertem InGaAs mit der Dicke d3 auf die Schicht 7 gewachsen ist. Die aufgrund des Überwachsens des Tunnelkontakts entstehende Überhöhung der Dicke d2 (=Überhöhungstiefe) in der Schicht 7 ist mit 15 gekennzeichnet. Üblicherweise wird die Kontaktschicht 8 in einem Epitaxie-Schritt aufgebracht und im Bereich der Überhöhung 15 durch selektives Ätzen entfernt. Die strukturierte Kontaktschicht 8 besitzt typischerweise eine Dicke d3 von 50 bis 100 nm, um niedrige Kontaktwiderstände zu gewährleisten, und weist am inneren Rand einen Abstand von mehreren Mikrometern (typischerweise 4-5 µm) zur Tunnelkontaktüberhöhung 15 auf. Bei der dargestellten Struktur entsteht in der Mitte eine um d2 größere Resonatorlänge als in den Bereichen außerhalb der Überhöhung 15. Der effektive Brechungsindex ist in der Mitte höher (typischerweise um 1 %) als im Außenbereich, wodurch eine starke Indexführung resultiert. Dies begünstigt die Ausbildung von höheren Moden, insbesondere bei großen Aperturen.

Zur Schwächung der Indexführung schlägt die Erfindung nunmehr vor, zumindest um den lateralen Bereich der Überhöhung 15 herum eine strukturierte Schicht aufzubringen, deren optische Dicke mindestens gleich der optischen Dicke der Stromführungsschicht 7 im Bereich der Überhöhung 15 ist, also der optischen Dicke der Überhöhung 15 mit Dicke d2. Die erfindungsgemäße strukturierte Schicht gleicht somit Brechungsindexunterschiede im Mittel- und Außenbereich der Überhöhung 15 aus, wodurch die Indexführung stark geschwächt wird.

Hierzu ist es erforderlich, dass die erfindungsgemäße strukturierte Schicht entweder an die Überhöhung 15 angrenzt oder einen bestimmten Höchstabstand zu der Überhöhung einhält. Es hat sich gezeigt, dass dieser Höchstabstand nicht mehr als 2 µm, vorzugsweise jedoch nicht mehr als 1 µm betragen sollte. Dieser Höchstabstand entspricht somit 40 - 50 %, vorzugsweise 20 -25 % des bisherigen typischen Abstands der (optionalen) Kontaktschicht 8 zum Außenrand der Überhöhung 15 (vergl. Figur 3).

Es erweist sich als vorteilhaft, wenn die erfindungsgemäße strukturierte Schicht eine n-dotierte Kontaktschicht ist.

Eine solche Kontaktschicht ist an sich aus dem Stand der Technik (siehe Figur 3) bekannt. In dieser Ausführungsform wird nunmehr die Dicke der Kontaktschicht derart bemessen, dass ihre optische Dicke beispielsweise gleich der optischen Dicke der Stromführungsschicht im Bereich der Tiefe d2 der Überhöhung 15 (vergl. Figur 3) ist, wobei für eine ausreichende Beeinflussung des optischen Feldes die Kontaktschicht nicht mehr als 1 - 2 µm von der Überhöhung entfernt liegen sollte.

In einer anderen Ausführungsform ist die erfindungsgemäße strukturierte Schicht unabhängig von der optionalen Kontaktschicht vorhanden. Sie ist materialseitig frei wählbar und grenzt vorzugsweise unmittelbar an die Überhöhung in der stromführenden Schicht an, wobei für einen eventuellen Abstand von der Überhöhung und für die Dicke dieser strukturierten Schicht das Analoge gilt wie für die Kontaktschicht als strukturierte Schicht. Die freie Materialwahl kann insbesondere dazu genutzt werden, um am Rand der Apertur höhere Moden aufgrund ihrer stärkeren Feldausläufer im Außenbereich stärker zu dämpfen, wodurch diese Moden nicht anschwingen können. Allgemein sind zu diesem Zweck Materialien geeignet, die für die jeweilige Laserwellenlänge stark absorbierend wirken. Für Wellenlängen zwischen 1,3 und 1,55 µm ist insbesondere amorphes Silizium geeignet. Für den gesamten üblichen Wellenlängenbereich eignet sich bspw. Titan.

Zusätzlich kann bei der genannten Ausführungsform eine die erfindungsgemäße strukturierte Schicht umgebende Kontaktschicht vorgesehen sein. Deren Geometrie ist im Wesentlichen frei wählbar, da der Wellenleitereffekt bereits durch die erfindungsgemäße strukturierte Schicht kompensiert wird.

Es hat sich gezeigt, dass durch die vorliegende Erfindung die Indexführung nicht nur geschwächt, sondern in ihr Gegenteil übergeführt werden kann, so dass ein Antiguiding-Effekt entsteht, der ebenfalls höhere Moden unterdrückt. Hierzu wird die (optische) Dicke der erfindungsgemäßen strukturierten Schicht bedeutend größer als die Tiefe der durch den Tunnelkontakt verursachten Überhöhung gewählt. Damit ergibt sich eine Überhöhung im Außenbereich. Falls die strukturierte Schicht dort absorbierend wirkt, ist die Unterdrückung höherer Moden nochmals effektiver. In dieser Ausführungsform mit Antiguiding-Effekt kann als strukturierte Schicht wieder eine n-dotierte Kontaktschicht verwendet werden oder eine Kombination aus einer materialseitig frei wählbaren Schicht als strukturierte Schicht mit einer optionalen zusätzlichen Kontaktschicht.

Im Folgenden soll die Erfindung anhand verschiedener in den Figuren dargestellter Ausführungsbeispiele näher erläutert werden.
- Figur 1: zeigt schematisch die Struktur eines vergrabenen Tunnelkontakts in einem bekannten oberflächenemittierenden Halbleiterlaser,
- Figur 2: zeigt schematisch die vollständige Struktur eines beispielhaften bekannten oberflächenemittierenden Halbleiterlasers,
- Figur 3: zeigt schematisch die Verhältnisse bei einer bekannten Struktur eines oberflächenemittierenden Halbleiterlasers hinsichtlich Kontaktschicht und Stromführungsschicht,
- Figur 4: zeigt eine bei der Herstellung eines oberflächenemittierenden Halbleiterlasers gemäß Erfindung entstehenden Strukturaufbau,
- Figur 5: stellt schematisch die Struktur einer Kontaktschicht als erfindungsgemäße strukturierte Schicht dar,
- Figur 6: stellt ein weiteres Ausführungsbeispiel dar, bei dem neben einer Kontaktschicht eine zusätzliche Schicht als erfindungsgemäße strukturierte Schicht vorhanden ist,
- Figur 7: zeigt eine weitere Ausführungsform mit Antiguiding-Effekt und
- Figur 8: zeigt schließlich eine Ausführungsform eines erfindungsgemäßen fertig gestellten oberflächenemittierenden Halbleiterlasers.

Bezüglich der Figuren 1 bis 3 wird auf weiter oben stehende Beschreibungsteile verwiesen.

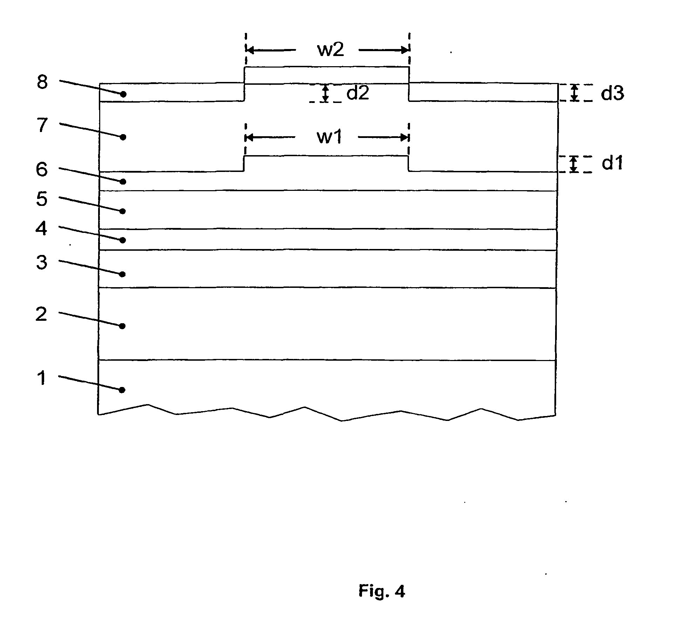

Figur 4 zeigt das Beispiel einer bei der Herstellung eines oberflächenemittierenden Halbleiterlasers entstehenden Struktur, wie sie im folgenden erläutert wird. Ausgehend von einem InP-Substrat 1 werden in einem ersten epitaktischen Wachstumsprozess nacheinander ein n-dotierter epitaktischer Bragg-Spiegel 2, eine n-dotierte Confinementschicht 3, eine aktive Zone 4 sowie eine p-dotierte Confinementschicht 5 aufgebracht. Die Struktur wird abgeschlossen durch das Wachstum einer Tunnelkontaktschicht 6, bestehend z. B. aus jeweils einer hoch p⁺- und n⁺-dotierten InGaAs-Schicht. Im nachfolgenden Lithographie- und Ätzprozess wird eine freidimensionierbare Apertur in Schicht 6 erzeugt, die entweder bis zur Schicht 5 reicht, oder innerhalb des p-dotierten Teils von Schicht 6 endet. Typische Ätztiefen sind hier bei 20 nm.

In einem zweiten Epitaxieschritt wird eine obere n-dotierte Stromzuführungsschicht 7, bestehend vorzugsweise aus InP, und eine optionale n-Kontaktschicht 8, bestehend vorzugsweise aus hoch n-dotierem InGaAs, gewachsen mit der Dicke d3. Bei diesem zweiten Epitaxieschritt kann je nach Prozessparametern oder je nach Epitaxieverfahren (z. B. MBE (Molecular Beam Epitaxy), CBE (Chemical Beam Epitaxy) oder MOVPE (Metal Organic Vapour Phase Epitaxy)) das laterale Halbachsenverhältnis modifiziert oder beibehalten werden. Eine Modifikation bewirkt z. B. eine elliptische Apertur vormals kreisrunder Tunnelkontakte.

Das Ergebnis ist in Figur 4 gezeigt, in der beispielsweise eine runde Apertur mit dem Durchmesser w1 als lithographisch definierte Apertur mit einer Ätztiefe d1 angenommen wird, die nach dem Überwachsen einen Durchmesser w2 aufweist mit einer Höhe d2. In der Regel entsprechen die Werte w2 und d2 den Ausgangsdaten w1 und d1.

Es sei hier ausdrücklich angemerkt, dass die vorliegende Erfindung auch bei anderen als kreisrunden Aperturen Anwendung finden kann, so dass die Begriffe "Durchmesser" oder "Radius" in der Beschreibung keine Beschränkung auf kreisrunde Aperturgeometrien bedeuten. Auch eckige, elliptische oder beliebig andere Geometrien sind möglich, wobei die Erfindung in einfacher Weise auf derartige Geometrien übertragbar ist.

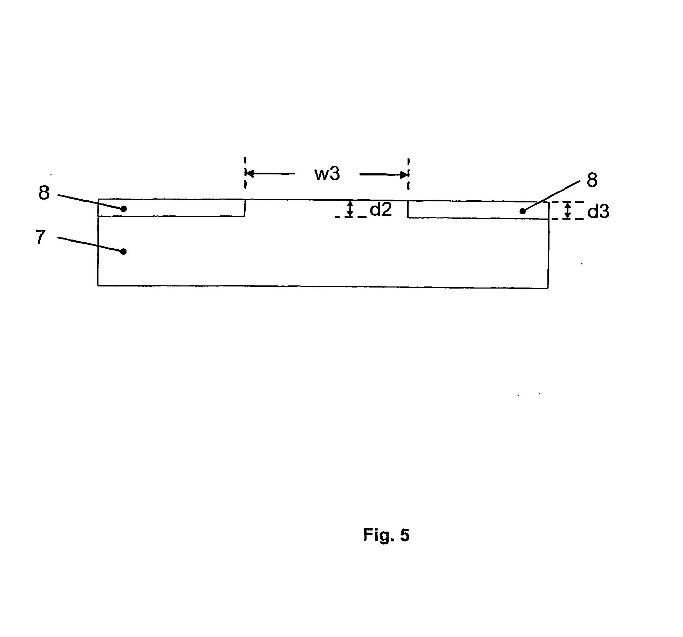

Ausgehend von der in Figur 4 dargestellten Struktur wird nun als erstes Ausführungsbeispiel die nach selektiver Ätzung der Kontaktschicht 8 erhaltene Struktur in Figur 5 gezeigt. Hier dient die Kontaktsicht 8 als erfindungsgemäße strukturierte Schicht. Die Dicke d3 der Kontaktschicht wird für eine vollständige Kompensation des Wellenleitereffektes zum Beispiel so gewählt, dass ihre optische Dicke der optischen Dicke im Bereich der Ätztiefe d2 von Schicht 7 entspricht. Es ergibt sich dann eine nahezu planparallele Anordnung. Der Ätzdurchmesser w3 kann dabei in bestimmten Bereichen nahezu beliebig eingestellt werden. Für eine ausreichende Beeinflussung des optischen Feldes sollte der Radius jedoch typischer Weise nicht mehr als 1 µm größer als der Tunnelkontaktradius sein. Weitere vorteilhafte Höschstabstände sind 0, 0,1, 0,2, 0,3, 0,4, 0,5, 0,6, 0,7, 0,8 und 0,9 µm.

Figur 5 zeigt deutlich die durch die Erfindung erzielten anderen Verhältnisse als die in Figur 3 beim Stand der Technik vorliegenden. Die erfindungsgemäße Strukturierung führt zu einer Vergleichmäßigung des effektiven Brechungsindex von der Mitte in die Außenbereiche der Apertur, wodurch die starke Indexführung, wie sie in Figur 3 vorliegt, durch eine schwache Indexführung ersetzt wird.

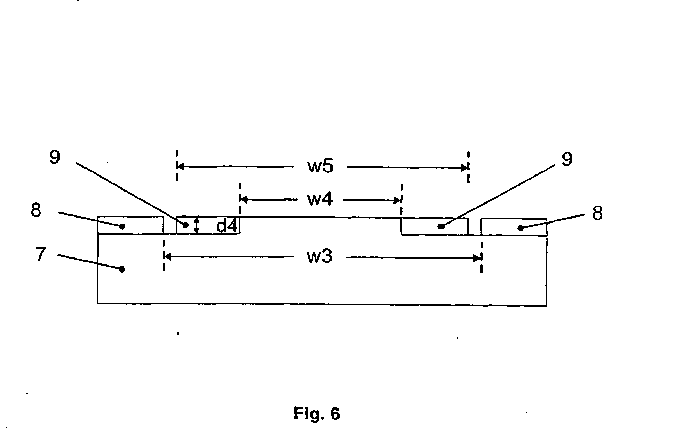

Figur 6 zeigt eine andere Ausführungsform der erfindungsgemäßen Wellenleiterstruktur. Die Kontaktschicht 8 ist bei dieser Anordnung nur optional vorhanden und kann in diesem Fall analog wie oben beschrieben mit einem Öffnungsdurchmesser w3 selektiv strukturiert sein. Die Beeinflussung der Wellenleitereigenschaften erfolgt in diesem Fall mit einer zusätzlichen und materialseitig frei wählbaren Schicht 9 mit Innendurchmesser w4 und Außendurchmesser w5, die z. B. durch Ätzverfahren oder Lift-Off-Technik strukturiert wird. Für die Dimensionierung der entscheidenden Dicke d4 sowie des Innendurchmessers w4 gilt Analoges wie im Falle der Kontaktschicht als strukturierte Schicht in Figur 5. Vorteil dieser Ausführungsform ist die freie Materialwahl der strukturierten Schicht 9. Dies kann insbesondere dazu genutzt werden, höhere Moden, die meist am Rand der Apertur ihre Maxima besitzen, stärker zu dämpfen, wodurch diese Moden nicht anschwingen können. Ein geeignetes Material für die Schicht 9 ist amorphes Silicium.

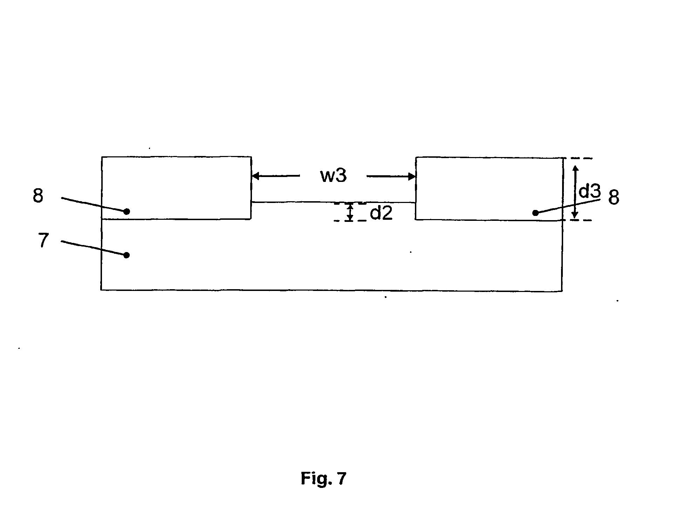

Figur 7 zeigt schließlich eine dritte Ausführungsform der erfindungsgemäßen Wellenleiterstruktur, die einen Antiguiding-Effekt besitzt. Diese Ausführungsform ähnelt der in Figur 5 beschriebenen, wobei hier jedoch die Dicke d3 der Kontaktschicht 8 als strukturierte Schicht bedeutend größer als die Überhöhungstiefe d2 bzw. Ätztiefe d1 des Tunnelkontakts gewählt ist. Damit ergibt sich eine Erhöhung im Außenbereich, die zu einem Antiguiding-Effekt führt und ebenfalls höhere Moden unterdrückt. Falls die Schicht 8 absorbierend wirkt, ist die Unterdrückung der Moden nochmals effektiver. Die in Figur 7 dargestellte Ausführungsform kann auch mit der im Bild 6 gezeigten Struktur kombiniert werden. In diesem Fall weist mindestens die Schicht 9 die dargestellte Überhöhung auf.

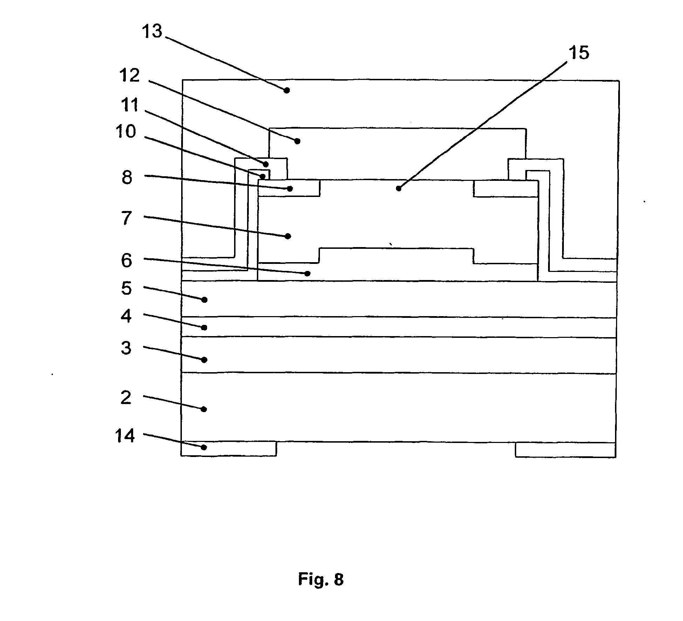

Figur 8 zeigt den fertigen erfindungsgemäßen BTJ-VCSEL, wobei die weitere Prozessierung der erfindungsgemäßen Struktur zum fertigen Halbleiterlaser bereits ausführlich in der Beschreibungseinleitung in Zusammenhang mit Figur 2 beschrieben wurde. Gleiche Bezugszeichen bezeichnen die gleichen Schichten wie in der Struktur gemäß Figur 4. Das InP-Substrat 1 ist hier vollständig entfernt. Stattdessen ist ein n-seitiger Kontakt 14 aus z. B. Ti/Pt/Au zur Stromzuführung aufgebracht. Die Wellenleiterstruktur des in Figur 8 dargestellten Halbleiterlasers entspricht der aus Figur 5 mit einer an die Überhöhung 15 angrenzenden Kontaktschicht 8. 10 bezeichnet eine Isolations- und Passivierungsschicht, 11 den p-seitigen Kontakt (z. B. Ti/Pt/Au), 12 den dielektrischen Spiegel und 13 die integrierte Wärmesenke.

Die Erfindung erlaubt die Herstellung von BTJ-VCSELs mit hoher Einmodenleistung. Die Aperturdurchmesser können zur Leistungssteigerung vergrößert werden, ohne dass höhere Moden angeregt werden.

## Patentansprüche

1. Oberflächenemittierender Halbleiterlaser, der eine einen pn-Übergang aufweisende aktive Zone (4), umgeben von einer ersten n-dotierten Halbleiterschicht (3) und mindestens einer p-dotierten Halbleiterschicht (5) aufweist, sowie eine Tunnelkontaktschicht (6) auf der p-Seite der aktiven Zone (4), wobei die Tunnelkontaktschicht (6) eine Apertur mit einem Aperturdurchmesser (w1) und einer Aperturtiefe (d1) aufweist und von einer n-dotierten Stromführungsschicht (7) bedeckt ist, so dass die angrenzende Stromführungsschicht (7) im Bereich der Apertur eine Überhöhung (15) mit einem Überhöhungsdurchmesser (w2) und einer Überhöhungstiefe (d2) aufweist,
**dadurch gekennzeichnet, dass**
auf der Stromführungsschicht (7) zumindest um den lateralen Bereich der Überhöhung (15) herum, angrenzend zu dieser oder einen Höchstabstand von 2 µm zu dieser Überhöhung (15) einhaltend, eine strukturierte Schicht (8; 9) vorgesehen ist, deren Dicke (d3; d4) derart gewählt ist, dass deren optische Dicke mindestens gleich der optischen Dicke der Stromführungsschicht (7) im Bereich der Überhöhungstiefe (d2) ist.

2. Halbleiterlaser nach Anspruch 1, **dadurch gekennzeichnet, dass** der halbe Innendurchmesser (w3; w4) der strukturierten Schicht (8; 9) maximal um 1 µm größer als der halbe Durchmesser (w2) der Überhöhung (15) ist.

3. Halbleiterlaser nach einem der Ansprüche 1 bis 2, **dadurch gekennzeichnet, dass** die strukturierte Schicht (8) eine n-dotierte Kontaktschicht (8) darstellt.

4. Halbleiterlaser nach Anspruch 3, **dadurch gekennzeichnet, dass** die strukturierte Schicht (8) aus n-dotiertem InGaAs besteht.

5. Halbleiterlaser nach einem der Ansprüche 1 bis 4, **dadurch gekennzeichnet, dass** die strukturierte Schicht (9) aus einem Material besteht, das für die jeweilige Wellenlänge des Halbleiterlasers signifikant absorbierend wirkt.

6. Halbleiterlaser nach Anspruch 5, **dadurch gekennzeichnet, dass** insbesondere im Wellenlängenbereich 1,3 bis 1,55 µm als Material amorphes Silizium verwendet wird.

7. Halbleiterlaser nach Anspruch 5, **dadurch gekennzeichnet, dass** als Material Titan verwendet wird.

8. Halbleiterlaser nach einem der Ansprüche 1 bis 2 oder 5 bis 7, **dadurch gekennzeichnet, dass** neben der strukturierten Schicht (9) eine n-dotierte Kontaktschicht (8) vorgesehen ist, die die strukturierte Schicht (9) lateral umgibt.

9. Halbleiterlaser nach Anspruch 1 oder 8, **dadurch gekennzeichnet, dass** die Dicke der strukturierten Schicht (8; 9) und/oder der Kontaktschicht (8) ein Vielfaches der Tiefe (d2) der Überhöhung (15) beträgt.

## Claims

1. Surface-emitting semiconductor laser comprising an active zone (4), which has a p-n-junction and is surrounded by a first n-doped semiconductor layer (3) and at least one p-doped semiconductor layer (5), and also a tunnel contact layer (6) on the p-side of the active zone (4), wherein the tunnel contact layer (6) comprises an aperture having an aperture diameter (w1) and an aperture depth (d1) and is covered by an n-doped current-carrying layer (7), so the adjacent current-carrying layer (7) comprises in the region of the aperture a raised portion (15) having a raised portion diameter (w2) and a raised portion depth (d2), **characterised in that** a structured layer (8; 9), the thickness (d3; d4) of which is selected in such a way that the optical thickness of said structured layer is at least equal to the optical thickness of the current-carrying layer (7) in the region of the raised portion depth (d2), is provided on the current-carrying layer (7), at least around the lateral region of the raised portion (15), adjacent thereto or within a maximum distance of 2 µm from this raised portion (15).

2. Semiconductor laser according to claim 1, **characterised in that** half the internal diameter (w3; w4) of the structured layer (8; 9) is at most 1 µm greater than half the diameter (w2) of the raised portion (15).

3. Semiconductor laser according to either claim 1 or claim 2, **characterised in that** the structured layer (8) is an n-doped contact layer (8).

4. Semiconductor laser according to claim 3, **characterised in that** the structured layer (8) consists of n-doped InGaAs.

5. Semiconductor laser according to any one of claims 1 to 4, **characterised in that** the structured layer (9) consists of a material having a significant absorbing effect for each wavelength of the semiconductor laser.

6. Semiconductor laser according to claim 5, **characterised in that** amorphous silicon is used as the material, in particular in the wavelength range from 1.3 to 1.55 *µ*m.

7. Semiconductor laser according to claim 5, **characterised in that** titanium is used as the material.

8. Semiconductor laser according to any one of claims 1 to 2 or 5 to 7, **characterised in that** an n-doped contact layer (8), which laterally surrounds the structured layer (9), is provided next to the structured layer (9).

9. Semiconductor laser according to either claim 1 or claim 8, **characterised in that** the thickness of the structured layer (8; 9) and/or of the contact layer (8) is a multiple of the depth (d2) of the raised portion (15).

## Revendications

1. Un laser semi-conducteur émetteur de surface comprenant une zone active (4) présentant une jonction p-n et entourée d'une première couche semi-conductrice (3) dopée n et au moins une couche semi-conductrice (5) dopée p bien qu'une couche de contact tunnel (6) sur la face p de la zone active (4), la couche de contact tunnel (6) comprenant une ouverture avec un diamètre d'ouverture (w1) et une profondeur d'ouverture (d1) et couverte d'une couche conductrice (7) dopée n de manière que la couche conductrice (7) adjacente présente, au niveau de l'ouverture, une élévation (15) avec un diamètre d'élévation (w2) et une profondeur d'élévation (d2),
**caractérisé en ce que**
sur la couche conductrice (7), au moins autour de la région latérale d'élévation (15), adjacente à ladite ou à une distance d'au plus 2 µm de ladite élévation (15), est prévue une couche structurée (8; 9) dont l'épaisseur (d3; d4) est choisie de manière que sa densité optique et au moins égale à la densité optique de la couche conductrice (7) dans la région de la profondeur d'élévation (d2).

2. Le laser semi-conducteur selon la revendication 1 **caractérisé en ce que** le diamètre interne moitié (w3; w4) de la couche structurée (8;9) est plus grand que le diamètre moitié (w2) de l'élévation (15) d'un maximum de 1 µm.

3. Le laser semi-conducteur selon une des revendications 1 à 2 **caractérisé en ce que** la couche structurée (8) est une couche contact dopée n (8).

4. Le laser semi-conducteur selon la revendication 3 **caractérisé en ce que** la couche structurée (8) est formée de InGaAs dopée n.

5. Le laser semi-conducteur selon une des revendications 1 à 4 **caractérisé en ce que** la couche structurée (9) est formée d'une matière ayant un effet absorbant significatif pour la longueur d'onde respective du laser semi-conducteur.

6. Le laser semi-conducteur selon la revendication 5 **caractérisé en ce que** le silicium amorphe est utilisé en particulier dans la plage de longueurs d'onde de 1,3 à 1,55 µm.

7. Le laser semi-conducteur selon la revendication 5 **caractérisé en ce que** le titane est utilisé comme ladite matière.

8. Le laser semi-conducteur selon une des revendications 1 à 2 ou 5 à 7 **caractérisé en ce qu'**outre la couche structurée (9) une couche contact dopée n (8) est prévue entourant lateralement la couche structurée (9).

9. Le laser semi-conducteur selon la revendication 1 ou 8 **caractérisé en ce que** l'épaisseur de la couche structurée (8; 9) et/ou de la couche contact (8) correspond à un multiple de la profondeur (d2) d'élévation (15).
